# EUROPEAN PATENT APPLICATION

(11) **EP 4 776 001 A1**
(43) Date of publication of application: **15.07.2026**
(21) Application number: 25170510.9
(22) Date of filing: 14.04.2025
(51) Int. Cl.: G01R 29/08, G01R 29/10

(54) **MULTI-FUNCTIONAL WIRELESS TEST PLATFORM**

(30) Priority: 14.01.2025 CN 202510058300
(71) Applicant: Velenova Limited, Kowloon Tong, KL (HK)
(72) Inventor: Lin, Quanwei, Hong Kong (HK); Ng, Kung Bo, Hong Kong (HK); Lee, Yat Wing, Hong Kong (HK); Leung, Ching Yee Angel, Hong Kong (HK); Man, Tui Dor, Hong Kong (HK)
(74) Representative: Loo, Chi Ching

(57) **Abstract**

The present application discloses a multi-functional wireless test platform, including: a multi-probe arc-shaped fixture (1) configured to hold multiple probe antennas, which are used to receive electric field data emitted by a device under test; a robotic arm (3) configured to drive the multi-probe arc-shaped fixture (1) to perform spherical scanning of the device under test with the device under test being the center of a sphere; a motion system (2, 6, 7) for the device under test configured to mount and drive the device under test to execute predetermined movements to cooperate and complete the spherical scanning; and a control system (9) used to determine the spherical scanning parameters, and to sample and analyse the electric field data emitted by the device under test to obtain its performance parameters. The present application can implement wireless testing of multiple functions using a single device, thereby significantly saving testing space and time costs.

## Description

### Technical Field

This application relates to wireless testing. Specifically, it relates to a multi-functional wireless test platform.

### Background Technology

In communication networks, antennas are an indispensable part of wireless connection products. The performance of an antenna directly affects the quality of the product and even the entire communication system. Therefore, it is necessary to perform radiation performance testing on its antenna separately during the wireless circuit design phase. Secondly, before a product is put into use, it is necessary to test its electromagnetic compatibility characteristics to assess whether the product will interfere with communication systems operating at other frequencies during use. Traditional antenna test platforms only have radiation performance testing capabilities, while testing electromagnetic compatibility characteristics requires an additional testing anechoic chamber.

### Summary of the Invention

The present application provides a multi-functional wireless test platform, including: a multi-probe arc-shaped fixture configured to hold multiple probe antennas, which are used to receive electric field data emitted by a device under test; a robotic arm configured to drive the multi-probe arc-shaped fixture to perform a spherical scanning of the device under test with the device under test being a center of a sphere; a motion system for the device under test configured to mount and drive the device under test to execute predetermined movements to cooperate and complete the spherical scanning; and a control system used to determine spherical scanning parameters, and to sample and analyse the electric field data emitted by the device under test to obtain performance parameters of the device under test.

In some embodiments of the present application, the motion system for the device under test includes: a device under test fixture for clamping the device under test, a turntable carrying the device under test fixture and driving the device under test to rotate horizontally with a center of the turntable as a center of a circle, and a lift station carrying the turntable and driving the turntable to move vertically.

In some embodiments of the present application, the motion system for the device under test is a detachable motion system for the device under test.

In some embodiments of the present application, determination of the spherical scanning parameters by the control system includes: determining a size and a shape of the device under test, obtaining a required scanning area and a scanning space size through calculation and analysis, and determining a test mode and a test range.

In some embodiments of the present application, the probe antennas include multiple dual-polarized sampling probe antennas, the multi-probe arc-shaped fixture comprises a 22.5-157.5 degree annular fixture, and the dual-polarized sampling probe antennas are evenly distributed along a circumferential direction of the 22.5-157.5 degree annular fixture and are oriented towards a center of the 22.5-157.5 degree annular fixture.

In some embodiments of the present application, a radio frequency switch is provided on the multi-probe arc-shaped fixture, the radio frequency switch is provided with multiple output ports, and the multiple dual-polarized sampling probe antennas and the multiple output ports are connected in a one-to-one correspondence.

In some embodiments of the present application, the radio frequency switch is a single-pole eight-throw radio frequency switch.

In some embodiments of the present application, the robotic arm is a multi-axis robotic arm terminal, and the multi-probe arc-shaped fixture and the multi-axis robotic arm terminal are nestedly connected to each other.

In some embodiments of the present application, the multi-probe arc-shaped fixture is hollowed out and is affixed with a wave-absorbing material.

In some embodiments of the present application, the multi-functional wireless test platform further includes: a vector network analyzer for performing vector network analysis.

This application can realize wireless testing of multiple functions on the same device, thus significantly saving testing space and time costs.

### Description of the Drawings

In order to make the technical problems solved by the present invention, the technical means adopted and the technical effects achieved more clearly, specific embodiments of the present invention will be described in detail with reference to the drawings. However, it should be noted that the drawings described below are only drawings of exemplary embodiments of the present invention. For those skilled in the art, drawings of other embodiments can be obtained based on these drawings without creative work.
Figure 1 shows a plane scanning test principle diagram of an embodiment of the present application.
Figure 2 shows a spherical scanning test principle diagram 1 of an embodiment of the present application.
Figure 3 shows a spherical scanning test principle diagram 2 of an embodiment of the present application.
Figure 4 shows a structure of the antenna test system of an embodiment of the present application.
Figure 5 shows a working principle diagram of the antenna test system of an embodiment of the present application.
Figure 6 shows a design principle diagram of an embodiment of the present application.

### Specific Embodiments

The exemplary embodiments of the present invention will now be described more comprehensively with reference to the accompanying drawings. Although each exemplary embodiment can be implemented in a variety of specific ways, it should not be understood that the present invention is limited to the embodiments described herein. On the contrary, these exemplary embodiments are provided to make the content of the present invention more complete and to facilitate the comprehensive communication of the inventive concept to those skilled in the art. Under the premise of being consistent with the technical concept of the present invention, the structure, performance, effect or other features described in a specific embodiment can be combined with one or more other embodiments in any suitable manner.

In the process of introducing specific embodiments, the detailed description of the structure, performance, effect or other features is to enable those skilled in the art to fully understand the embodiments. However, it is not excluded that those skilled in the art can implement the present invention in a technical solution that does not contain the above-mentioned structure, performance, effect or other features under certain circumstances.

The same reference numerals in the drawings represent the same or similar elements, components or parts, and thus the repeated description of the same or similar elements, components or parts may be omitted below. It should also be understood that although the first, second, third and other numbered terms may be used herein to describe various devices, elements, components or parts. These devices, elements, components or parts should not be limited by these terms. That is to say, these attributes are only used to distinguish one from another. For example, the first device can also be called the second device, but it does not deviate from the essential technical solution of the present invention. In addition, the term "and/or" refers to all combinations including any one or more of the listed items.

The present application relates to a multi-functional wireless test platform based on multi-probe scanning. The test platform can use robotic arm scanning and independently developed near-far field conversion algorithms to implement wireless tests of multiple functions on the same device, such as the conversion of antenna radiation performance test and electromagnetic compatibility test, thereby significantly saving testing space and time costs.

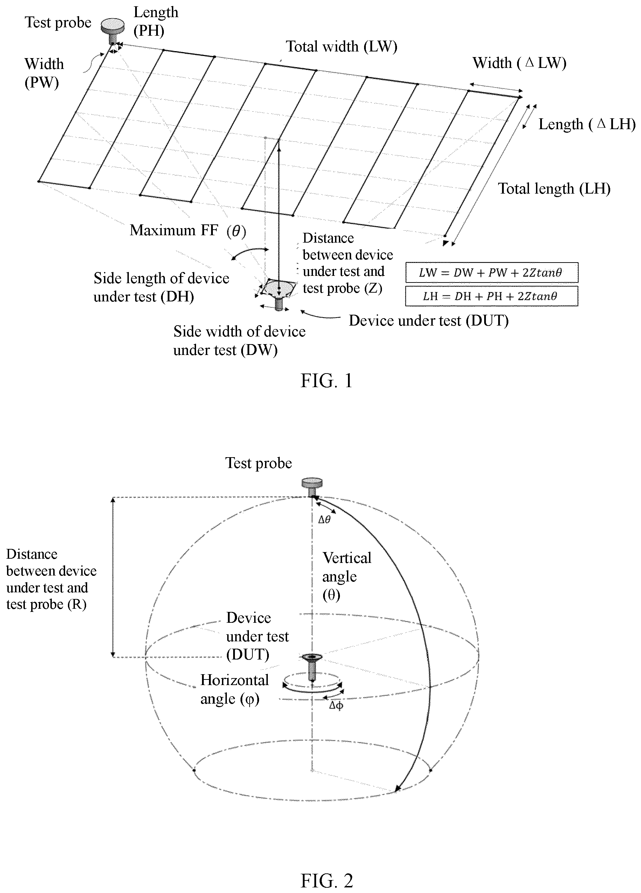

Figure 1 shows a schematic diagram of a plane scanning test of an embodiment of the present application. As shown in Figure 1, the test probe can perform plane sampling on the device under test (in this application, device under test and object under test are used interchangeably to refer to the same thing), for example, in a scanning plane with a total length LH and a total width LW, wherein, LH=DH+PH+2Ztan^{θ}, LW=DW+PW+2Ztan^{θ}. DH is the side length of the device under test, DW is the side width of the device under test, PH is the length of the test probe, PW is the width of the test probe, Z is the distance between the device under test and the test probe in a normal direction of the sampling plane, and θ is the angle between the test probe and the normal direction of the sampling plane.

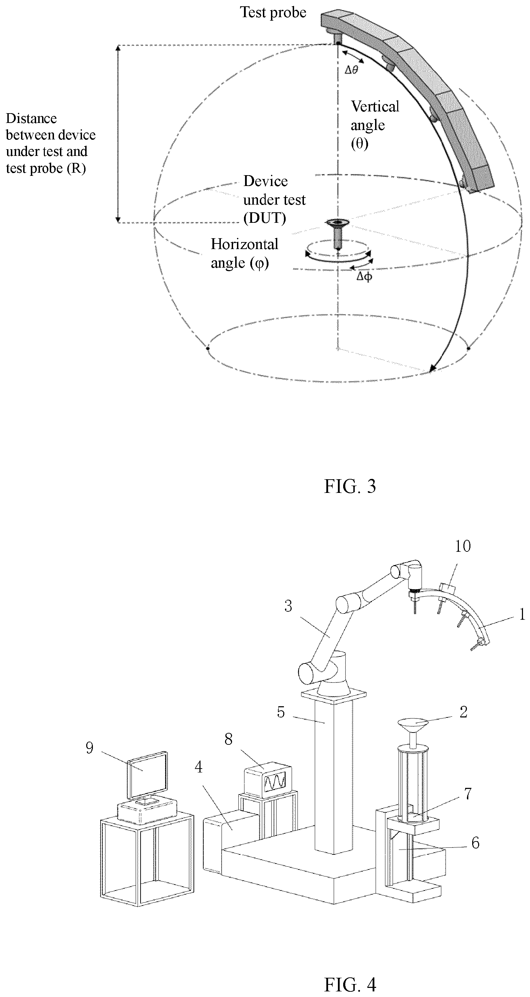

Figure 2 shows the spherical scanning test principle diagram 1 of an embodiment of the present application. Figure 3 shows the spherical scanning test principle diagram 2 of an embodiment of the present application. Among them, Figure 2 shows spherical far-field cut sampling, and Figure 3 shows multi-probe spherical near-field cut sampling. It can be seen that the device under test can be placed in a spherical field, and can be rotated in a horizontal direction. The test probes can be placed on the spherical surface and move along the spherical surface. The test probe can be a single probe shown in Figure 2, or a multi-probe shown in Figure 3.

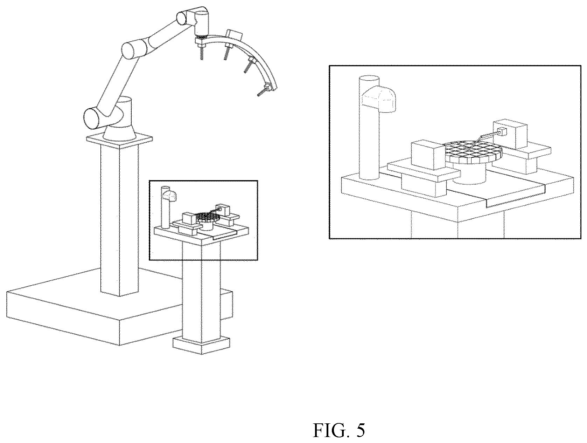

Figure 4 shows the structure of the antenna test system of an embodiment of the present application. Figure 5 shows the working principle diagram of the antenna test system of an embodiment of the present application. As shown in Figures 4 and 5, the test system may include:
1. A test probe fixture 1, which is used to clamp the test probes. The test probes may be provided with a power receiver for receiving the electric field data emitted by the device under test.
2. Device Under Test (DUT) fixture 2, used to hold the device under test.
3. Robotic Arm 3, used to move the test probe fixture.
4. Controller 4, used to control the operation of the entire test system.
5. Robotic Arm Stand 5, used to carry the robotic arm.
6. Lift Station 6, used to lift and lower the device under test fixture.
7. Turntable 7, used to rotate the device under test fixture.
8. Vector Network Analyzer (VNA) 8, used to perform vector network analysis during the test.
9. Supporting Program (software sub system) 9, which is the supporting software of the hardware of the entire test system, and is used to support corresponding operation of each hardware component. That is, it can be used as a control system of the entire test system. For example, it can be used to determine the spherical scanning parameters, and to sample and analyze the electric field data emitted by the object under test to obtain the performance parameters of the object under test.
10. A single-pole eight-throw (SP8T) radio frequency switch circuit (1-to-8 Switch) 10 is used to switch the operation of each test probe and obtain the data of the test probe.

As can be seen from Figures 1-5, the multi-functional wireless test platform based on multi-probe scanning of the present application includes a multi-probe sampling system, a detachable motion system for the device under test, a near-field and far-field measurement system, and a control software. The multi-probe sampling system can be composed of a 22.5-157.5 degree annular fixture (arc-shaped fixture) 1 centered on the object under test, which is equipped with multiple probe antennas that can receive dual-polarized electric fields. The dual-polarized sampling probe antennas are evenly distributed along the circumference of the fixture and are oriented towards the center of the fixture 1. The fixture 1 equipped with the probe antennas is driven by the robotic arm 3 to perform a semi-circular trajectory scan in space with the object under test as the center of a sphere to receive the electric field data radiated by it. The multi-probe sampling system can be provided with a radio frequency switch 10, and the radio frequency switch 10 can be provided with output ports. The dual-polarized sampling probe antennas are connected to the multiple output ports in a one-to-one correspondence. The annular fixture 1 can be nested with a multi-axis robotic arm terminal. The annular fixture 1 can be hollowed out and can be affixed with a wave-absorbing material.

The detachable motion system for the device under test can be used to install the device under test, i.e., the object under test, and can drive the object under test (through the lift station 6) to move up and down in a vertical direction of the ground so that the object under test is at the center of the arc-shaped fixture 1, and there is a turntable (i.e., rotating platform) 7 to drive the object under test to rotate with the center of the turntable as the center of a circle, and cooperate with the above-mentioned multi-probe fixture 1 to complete the spherical trajectory scanning. In addition, there is a simple nesting device on it, which is convenient for disassembling and installing other types of object under test platforms. The detachable motion system for the device under test and a robotic arm stand 5 can be provided with a nesting device that is convenient for loading and unloading the object under test placement platform. In other words, the detachable motion system for the device under test can be used to install and drive the device under test to perform a predetermined movement to cooperate and complete the spherical scanning of the device under test by the multi-probe arc-shaped fixture driven by the robotic arm with the device under test as the center of a sphere.

The near-field and far-field measurement system can be used to test and sample the signals radiated by the object under test, and analyze and calculate to obtain the performance parameters of the object under test. The near-field and far-field measurement system can include a test radiation total power subsystem, which can include a power receiver and a radio frequency switch installed on the probe.

The control software (supporting program 9) can be constructed to determine the size and shape of the object under test, and obtain the required scanning area and scanning space size through calculation and analysis, and recommend a testable mode and a test range to the tester based on the result of a simulator simulation, so as to avoid collision and damage of the test components during the scanning process.

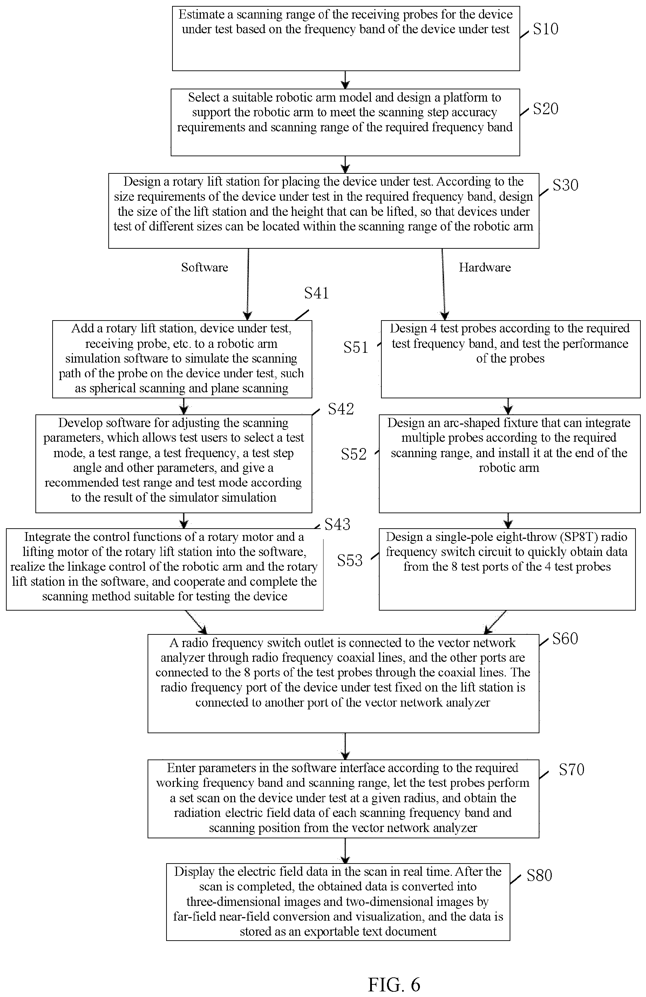

Figure 6 shows the design principle diagram of an embodiment of the present application, which includes:
S10) Estimate a scanning range of the receiving probes for the device under test based on the frequency band of the device under test.

**In** this step, first, according to the required test frequency band of the device under test, the corresponding electromagnetic wave's wavelength range is calculated, so as to estimate the spherical scanning radius and plane scanning distance of the receiving probe for the device under test (generally 5-7 times the wavelength of the frequency band). This part determines the arc radius, scanning time and test accuracy of the fixture used to fix the multi-probe.

S20) Select a suitable robotic arm model and design a platform to support the robotic arm to meet the scanning step accuracy requirements and scanning range of the required frequency band.

S30) Design a rotary lift station for placing the device under test. According to the size requirements of the device under test in the required frequency band, design the size of the lift station and the height that can be lifted, so that devices under test of different sizes can be located within the scanning range of the robotic arm.

**In** steps S20 and S30, a suitable robotic arm can be selected according to the size of the scanning range. According to the frequency range of the device under test, the size of such device can also be estimated, so that according to these parameters, the components of the rotary lift station for rotation and lifting can be designed. The lifting height can be designed according to the scanning range, so that different devices in the frequency band can be located within the scanning range of the robotic arm by adjusting the height of the lift station.

The next operation can be divided into two parts, i.e., software and hardware, and can be carried out simultaneously. **In** the software part, it can include:
S41) Add a rotary lift station, device under test, receiving probe, etc. to a robotic arm simulation software to simulate the scanning path of the probe on the device under test, such as spherical scanning and plane scanning.

S42) Develop software for adjusting the scanning parameters, which allows test users to select a test mode, a test range, a test frequency, a test step angle and other parameters, and give a recommended test range and test mode according to the result of the simulator simulation.

S43) Integrate the control functions of a rotary motor and a lifting motor of the rotary lift station into the software, realize the linkage control of the robotic arm and the rotary lift station in the software, and cooperate and complete the scanning method suitable for testing the device.

In the hardware part, it can include:
S51) Design 4 test probes according to the required test frequency band, and test the performance of the probes.

S52) Design an arc-shaped fixture that can integrate multiple probes according to the required scanning range, and install it at the end of the robotic arm.

S53) Design a single-pole eight-throw (SP8T) radio frequency switch circuit to quickly obtain data from the 8 test ports of the 4 test probes.

It can be seen that the software part adds the rotary lift station, device under test sample, receiving probe, and other components to the robotic arm simulation software, so as to simulate the scanning path of the probe on the device under test, and designs the form of spherical scanning and plane scanning. The purpose of this process is to avoid damage to the test components. In the real test scanning environment, all test probes and the device under test are connected to a vector network analyzer through coaxial cables of limited length. If the scanning range exceeds a certain threshold, the cables will be entangled and the components will be damaged. Therefore, the simulation and observation of the robotic arm's action in advance in the simulator can reduce the risk of scrapping of the components. Then, develop a control software that allows users to select test parameters independently. The interface of the software can provide test modes, test ranges, test frequencies, test step angles and other parameters for the users to choose, and recommend a testable mode and a test range to the tester based on the result of the simulator simulation, so as to avoid collision and damage of the test components during the scanning process. Finally, the control functions of the rotary motor and the lifting motor in the rotary lift station are integrated into the software, and the control is linked with the control of the robotic arm to complete the scanning action suitable for testing of the device. In terms of hardware, four dual-polarized test probes need to be designed first, and the performance of the test probes needs to be tested to ensure that they meet the requirements of electromagnetic calculation. Then, according to the scanning range required by the device under test, a circular arc-shaped fixture that can integrate four test probes is designed and installed at the end of the robotic arm. **In** order to quickly obtain test information of the four probes, a single-pole eight-throw (SP8T) radio frequency switch circuit needs to be designed.

After completing the software and hardware design, the process continues to include:
S60) A radio frequency switch outlet is connected to the vector network analyzer through radio frequency coaxial lines, and the other ports are connected to the 8 ports of the test probes through the coaxial lines. The radio frequency port of the device under test fixed on the lift station is connected to another port of the vector network analyzer.

S70) Enter parameters in the software interface according to the required working frequency band and scanning range, let the test probes perform a set scan on the device under test at a given radius, and obtain the radiation electric field data of each scanning frequency band and scanning position from the vector network analyzer.

S80) Display the electric field data in the scan in real time. After the scan is completed, the obtained data is converted into three-dimensional images and two-dimensional images by far-field near-field conversion and visualization, and the data is stored as an exportable text document.

It can be seen that after the software and hardware design is completed, the radio frequency connection needs to be made. The outlet of the radio frequency switch is connected to the vector network analyzer through the radio frequency coaxial lines, and the other ports are connected to the 8 ports of the test probes through the coaxial lines, The radio frequency input port of the device under test fixed on the lift station is connected to another port of the vector network analyzer. **In** order to cooperate with the probe platform test and the antenna-in-package (AiP) test on the market, the rotary lift station can be designed as a detachable component. The user can replace the device under test as needed. Then, input the parameters in the software interface according to the required working frequency band and scanning range, let the test probe scan the device under test at a set radius, and obtain the radiation electric field data of each scanning frequency band and scanning position from the vector network analyzer. The electric field data in the scan is displayed in real time in the software. After the scan is completed, the obtained near-field data is converted and processed from the near-field to the far-field to obtain the far-field data required for the test, and visualize and convert into three-dimensional and two-dimensional images. The data is then stored as an exportable text document.

**In** general, the present application relates to a test system for testing antenna radiation performance and electromagnetic compatibility performance, which is composed of hardware and software. The hardware mainly includes a robotic arm, a detachable rotary lift station, test probes composed of multiple receiving antennas, a radio frequency switch circuit, a vector network analyzer, etc. The software functions include test calculation algorithms and mechanical control software, such as motor control of the robotic arm and the rotary lift station, test scenario setting, test near-field and far-field data conversion algorithm, and graphical display of test results. The probes on the robotic arm can be controlled to scan the device under test on the rotary lift station along a specific spherical and planar trajectory. Emphasis is on applying multiple and single probes, and performing spherical and planar scanning for the probe platform test and the Antenna-in-Package (AiP) test. The acquired data is converted into far-field data through the near-field and far-field conversion algorithm. The receiving antennas are replaced with electromagnetic compatibility receiving probes, and the control software can determine the size and shape of the device under test, obtain the required scanning area and scanning space size through calculation and analysis, perform spherical and planar scanning on the device under test, and convert the electric field radiated by the device under test into electromagnetic compatibility variation data.

The main purpose of this application is to test the radiated electric field of wireless devices, receive the near-field electric field close to the device under test, and convert it into far-field radiated electric field in practical applications, so that wireless device designers and electromagnetic field compatibility assessment agencies can use it as reference data to evaluate the radiation performance of the device under test, such as electric field strength, maximum radiation direction, radiation efficiency, antenna gain, electromagnetic interference, etc.

From a technical point of view, the present application adopts automatic scanning by a robotic arm to realize the reception and calculation of the radiated electric field of the device under teat. However, unlike the previously existing robotic arm test platform, the present application adds a rotatable lift station (rotary lift station, i.e., a collective term for the lift station 6 and the turntable 7) and a device that can easily disassemble the rotary lift station to increase the scanning range of the robotic arm, and utilizes a multi-probe receiving method and a fixture to reduce the testing time. When the traditional robotic arm-based testing technology performs scanning tests, the robotic arm is not flexible enough. When it needs to perform large-angle scanning, such as using a single probe to scan the object under test at nearly 165 degrees, it will not be possible to scan more than 90 degrees due to the large scanning radius. Alternatively, although it can exceed 90 degrees, the direction of the probe will change and cannot be consistent with the orientation of the object under test. Therefore, the scanning radius limits the existing technology to near-field scanning within a certain frequency band. The present application uses a rotary lift station and a multi-probe arc-shaped fixture to increase the scanning range to a certain extent, so that each time the rotary station rotates a certain horizontal angle, it can scan the object under test between 165 degrees and 170 degrees, thereby achieving a more complete spherical scan, which not only broadens the measurable frequency band range, but also enables it to test more parameters that require a complete sphere, such as electromagnetic compatibility (EMC), total radiated power (TRP), equivalent isotropic radiated power (EIRP), etc.

The antenna radiation and electromagnetic compatibility test platform based on the robotic arm of the present application is at least one-third smaller than the traditional antenna test platform. The number of probes is reduced by three-quarters, so the cost is reduced by two-thirds compared to the traditional scheme, making it more commercially competitive and reducing the burden of R&D costs for the industry engaged in the R&D of related products. At the same time, the multiple sets of probes cooperate with fast conversion algorithms to maintain the test time. Due to the flexibility of scanning space, storage space and scanning function, this application is suitable for full-band wireless testing from Wi-Fi's 2.45 GHz to 300 GHz terahertz frequency band. It is suitable for product radiation testing in today's 5G communication, autonomous driving, Internet of Things, and even future 6G and satellite communication. This helps to improve the technological development of the electronics and communications industry.

More specifically, the advantages of this application include:
1. The test platform for placing the device under test cannot only be lifted and lowered, but also can be disassembled and installed with other test platforms. It is equipped with positioning and snap-on devices to ensure that the device under test is lifted and lowered on a stable horizontal plane. The range of the scanning radius can be increased and decreased. For low-frequency devices, near-field scanning calculation can be used, and for high-frequency devices, far-field scanning calculation can be used.
2. This application adopts a four-probe dual-polarization receiving method, which reduces the test time by 3/4 compared to the traditional single receiving probe.
3. The multi-probe method can be compatible with different test modules at the same time, so that the test platform supports parameters other than the antenna radiation electric field, such as testing electromagnetic compatibility (EMC), total radiated power (TRP), equivalent isotropic radiated power (EIRP), etc.

The above embodiments are only used to illustrate the technical solutions of the present invention, rather than to limit them. Although the present invention is described in detail with reference to the above embodiments, technicians ordinarily skilled in the art should understand that they can still modify the technical solutions disclosed in the above embodiments, or replace some of the technical features therein with equivalents. These modifications or replacements do not make the essence of the corresponding technical solutions deviate from the scope of the technical solutions of the embodiments of the present invention.

The above embodiments only express several implementation methods of the present application, and the description is relatively specific and detailed. However, it cannot be understood as a limitation on the scope of the patent application. It should be pointed out that for technicians ordinarily skilled in the art, without departing from the concept of the present application, several alternations and improvements can be made, which all belong to the scope of protection of the present application. Therefore, the scope of protection of the patent of this application shall be based on the attached claims.

## Claims

1. A multi-functional wireless test platform, **characterized in that** it comprises:
a multi-probe arc-shaped fixture (1) configured to hold multiple probe antennas, which are used to receive electric field data emitted by a device under test;
a robotic arm (3) configured to drive the multi-probe arc-shaped fixture (1) to perform a spherical scanning of the device under test with the device under test being a center of a sphere;
a motion system (2, 6, 7) for the device under test configured to mount and drive the device under test to execute predetermined movements to cooperate and complete the spherical scanning; and
a control system (9) used to determine spherical scanning parameters, and to sample and analyse the electric field data emitted by the device under test to obtain performance parameters of the device under test.

2. The multi-functional wireless test platform as claimed in claim 1, **characterized in that**, the motion system (2, 6, 7) for the device under test comprises: a device under test fixture (2) for clamping the device under test, a turntable (7) carrying the device under test fixture (2) and driving the device under test to rotate horizontally with a center of the turntable (7) as a center of a circle, and a lift station (6) carrying the turntable (7) and driving the turntable (7) to move vertically.

3. The multi-functional wireless test platform as claimed in claim 1, **characterized in that**, the motion system (2, 6, 7) for the device under test is a detachable motion system for the device under test.

4. The multi-functional wireless test platform as claimed in claim 1, **characterized in that**, determination of the spherical scanning parameters by the control system (9) comprises: determining a size and a shape of the device under test, obtaining a required scanning area and a scanning space size through calculation and analysis, and determining a test mode and a test range.

5. The multi-functional wireless test platform as claimed in claim 1, **characterized in that**, the probe antennas comprise multiple dual-polarized sampling probe antennas, the multi-probe arc-shaped fixture (1) comprises a 22.5-157.5 degree annular fixture, and the dual-polarized sampling probe antennas are evenly distributed along a circumferential direction of the 22.5-157.5 degree annular fixture and are oriented towards a center of the 22.5-157.5 degree annular fixture.

6. The multi-functional wireless test platform as claimed in claim 5, **characterized in that**, a radio frequency switch (10) is provided on the multi-probe arc-shaped fixture (1), the radio frequency switch (10) is provided with multiple output ports, and the multiple dual-polarized sampling probe antennas and the multiple output ports are connected in a one-to-one correspondence.

7. The multi-functional wireless test platform as claimed in claim 6, **characterized in that**, the radio frequency switch (10) is a single-pole eight-throw radio frequency switch.

8. The multi-functional wireless test platform as claimed in claim 1, **characterized in that**, the robotic arm (3) is a multi-axis robotic arm terminal, and the multi-probe arc-shaped fixture (1) and the multi-axis robotic arm terminal are nestedly connected to each other.

9. The multi-functional wireless test platform as claimed in claim 1, **characterized in that**, the multi-probe arc-shaped fixture (1) is hollowed out and is affixed with a wave-absorbing material.

10. The multi-functional wireless test platform as claimed in claim 1, **characterized in that**, it further comprises: a vector network analyzer (8) for performing vector network analysis.
